# EUROPEAN PATENT SPECIFICATION

(11) **EP 0 720 244 B1**
(45) Date of publication and mention of the grant of the patent: **12.06.2002**
(21) Application number: 96101288.7
(22) Date of filing: 28.03.1988
(51) Int. Cl.: H01L 39/14, H01L 39/24, C04B 35/65

(54) **Superconducting oxide-metal composites**
Supraleitende Oxid-Metall Verbundmaterialien
Composites oxyde-métal supra-conducteurs

(30) Priority: 27.03.1987 US 31407; 10.06.1987 US 61233
(43) Date of publication of application: 03.07.1996
(62) Divisional of application: 88302739.3
(73) Proprietor: MASSACHUSETTS INSTITUTE OF TECHNOLOGY, Cambridge, MA 02139 (US)
(72) Inventor: Yurek, Gregory J., Wellesley, Massachusetts 02181 (US); VanderSande, John B., Newbury, Massachusetts 01951 (US)
(74) Representative: Beetz & Partner Patentanwälte

(56) References cited:
- DE-A- 2 516 747
- JAPANESE JOURNAL OF APPLIED PHYSICS, vol. 26, no. 4, April 1987 pages l334-l336, K. MATSUKAKI ET AL. 'Preparation of a High Tc Superconductor by Oxidation of an Amorphous La1.8Sr0.2Cu Alloy Ribbon in Air'
- PHYSICAL REVIEW LETTERS, vol. 58, no. 4, 26 January 1987 pages 405-407, C.W. CHU ET AL. 'Evidence for Superconductivity above 40 k in the La-Ba-Cu-O Compound Sustem'

## Description

Superconductors are materials having essentially zero resistance to the flow of electrons below a certain critical temperature, T_{c}. It is known that certain metal oxides, e.g., La₂₋ₓBaₓCuO_{4-y}, La₂₋ₓSrₓCuO_{4-y}, Ba₂YCu₃O_{9-y}, etc. exhibit superconductivity. It has been discovered that a europium-barium-copper oxide compound in which the europium, barium and copper are in a ratio of 1:2:3, that is, EuBa₂Cu₃Oₓ, exhibits superconductivity with a transition temperature at approximately 85 K. It is desirable to provide such oxides in forms, e.g., wires or thin films, that permit practical utilization of their superconductive property.

In the past such superconducting oxides were prepared by mixing the individual metal oxide particles to a powdered mixture, forming the mixture into a desired shape, especially into a wire or a ribbon, and sintering and annealing the shaped body in a controlled atmosphere. An essential disadvantage of these superconductive oxide products resides, however, in the mechanical properties thereof, particularly in their extremely high brittleness and hardness which considerably impede processing and forming and, thus, are an obstacle to a universal application. In the sintering process and especially in the subsequent cooling microcracks come into existence which, during application, hinder the current passage in a similar way as in the case of inhomogeneous areas in the sintered body, and which lead, due to the increased electrical resistance during operation, to a local heating beyond the critical temperature T_{c}.

In a portion of non-prepublished EP-A-0 283 024 based on JP Patent Application 67 647/87 there is disclosed a method for manufacturing a superconductor containing a ceramic superconductive oxide. In this method, the metal elements of the superconductive oxides are melted to an alloy, and this is formed to a fine wire of about 100 µm in diameter or to a thin ribbon of about 100 µm in thickness by passing through a fine hole or nozzle. To obtain an amorphous structure, the wire or ribbon is injected into a liquid cooling medium. Then, the rapidly solidified amorphous wire or ribbon is oxidized in a furnace for a time period of 2 hours at a high temperature of more than 1000 °C in a controlled oxygen atmosphere in order to obtain a superconductive conductor containing a superconductive ceramic material.

Further, in the non-prepublished EP-A-0 282 839 there is disclosed the preparation of a film of superconductive oxides by vapour deposition processes in which multiple metal sources are used. The pure metal vapours of each of these sources travel to a heated substrate which is exposed to an oxygen ambient for forming a metal oxide film of 1000 Å (1Å = 10⁻¹⁰ m) to 1 µm thickness on the substrate. Afterwards this film is annealed at a high temperature of about 900 °C in an oxygen atmosphere for obtaining superconductive properties.

Further, in a portion of the non-prepublished EP-A-0 282 286 based on JP-A-56 856/87 there is disclosed a method for producing a compound superconductive silver wire containing a predetermined amount of superconductive oxides in the silver matrix. In this method, a melted silver alloy containing 70 to 90 wt.% of silver and the elements that form a superconductive oxide is formed to a wire or ribbon, preferably by swaging, wire drawing or rolling. The prepared silver alloy wire is then heated for a predetermined time period at a temperature between 500 and 900 °C in an oxidizing atmosphere to form perovskite-type superconducting oxides in the silver matrix.

The problem underlying the present invention is to provide superconducting oxide-metal composites wherein the continuous superconducting oxide phase is intimately mixed with a noble metal phase, and which show improved strength and ductility, and to provide superconducting wires, coils and magnets comprising these composites.

This problem is solved in accordance with the independent claims.

The dependent claims relate to preferred embodiments of the invention.

The superconducting oxide-metal composite according to the present invention comprises a substantially continuous oxide superconducting phase intimately mixed with a noble metal phase, the noble metal acting as a skeleton in the composite, thereby providing it with improved strength and ductility; it is obtainable by
- combining the metallic elements of the oxide and a noble metal to form an alloy,
- forming the alloy into a desired shape,
- oxidizing the formed alloy in a first heating step at a first temperature in oxygen or in an oxygen-containing atmosphere,
   and
- raising the temperature to a second temperature higher than the first temperature and lower than the melting temperature of the noble metal to form the superconducting oxide phase in a second heating step at that second temperature, until the weight of the sample is constant.

The alloy can be formed, e.g., into a wire, ribbon, sheet, rod, or ring. The solid alloys used to make these articles can be produced from the liquid state by rapid or conventional solidification processing techniques to produce, e.g., ribbons, powders, flakes, ingots, sheets, or cast shapes. Rapid solidification processing techniques include melt spinning to produce ribbons and inert gas atomization to produce powders or spray deposits. Conventional solidification processing techniques include chill casting, ingot casting, die casting, and centrifugal casting. Thermomechanical processing of the solid alloys can be employed to form them into final, useful shapes before oxidizing the alloys into the superconducting oxide. Thermomechanical processing techniques include wire drawing, extrusion, coextrusion, hot isostatic pressing, and rolling.

The alloy can also be provided in the form of a relatively thick coating, e.g., on a tube, wire, rod, or shaped article such as a ring. Relatively thick coatings of the alloys can be produced by coextrusion of the alloy powder with a billet of a substrate metal or metal alloy to form wires, rods, or tubes. Alloy coatings can also be produced by plasma spraying or sputtering the alloy constituents onto a substrate metal or metal alloy that can be in many useful shapes, e.g., a tube formed into the shape of a ring. Furthermore, alloy coatings can be produced by hot dipping the substrate metal or metal alloy, e.g., in a wire form, in the liquid alloy.

The alloy before oxidation can also be in the form of a thin film on a metallic, insulating, or semiconducting substrate, e.g., as used in a Josephson junction device of an integrated circuit. Thin films of the alloy can be produced by chemical vapour deposition, vacuum evaporation, sputtering, molecular beam epitaxy, ion-beam mixing, and ion implantation.

By a "noble" metal is meant a metal whose oxide is thermodynamically unstable under the reaction conditions employed relative to the superconducting oxide that forms.

In preferred embodiments, the noble metal is present initially as an alloying element with the metallic elements of the oxide: the alloy is then oxidized under conditions that convert the metallic elements of the oxide to the superconducting oxide without oxidizing the noble metal. The latter precipitates as a finely divided, substantially pure metal phase (rather than as a second oxide phase) that is intimately mixed with the superconducting oxide in the final composite, the oxide phase being continuous (nor nearly so) throughout the composite. The noble metal may be a metallic element different from the metallic elements of the oxide, e.g., Au, Pt, Pd, or Ag. The superconducting oxide-metal composites exhibit improved mechanical properties (strength, ductility, etc.) because these properties are dominated by the metallic phase, rather than by the brittle oxide phase.

Examples of suitable oxides are described in the following references, hereby incorporated by reference and made part of this specification: Chu et al. (1987) Phys. Rev. Lett. 58(4) 405-07; Cava et al. (1987) Phys. Rev. Lett. 58(4) 408-10; Wu et al. (1987) "Superconductivity at 93K in a New Mixed Phase Y-Ba-Cu-O Compound System at Ambient Pressure"; Hor et al. (1987) "High Pressure Study of the New Y-Ba-Cu-O Superconducting Compound System"; Tarascon et al. (1987) "Superconductivity at 90K in a Multi-Phase Oxide of Y-Ba-Cu"; Gleick, "Superconductivity: A new Era of Discovery for Electricity", N.Y. Times, Mar. 10, 1987; and Tarascon et al. (1987) Science 235: 1373-76. They include e.g. oxides of La, Ba and Cu; La, Sr and Cu; Lu, Ba and Cu; Lu, Sr and Cu; and Y, Ba and Cu. The invention is of course applicable to any superconducting oxide. A europium-barium-copper oxide has been found to be particularly preferred, namely EuBa₂Cu₃Oₓ. The present invention encompasses other compounds including europium.

The invention is hereinafter more particularly described with reference to the following examples:

### Example 1

A superconducting oxide-metal composite in which the oxide phase is an oxide of La, Ba, and Cu, and the metallic phase is a noble metal such as Ag, is prepared as follows. Ag metal is melted together with La, Ba, and Cu under vacuum in an induction melting furnace in a melt spinning apparatus. The liquid alloy is heated to approximately 800 °C, and then melt spun to produce a ribbon of the alloy.

The alloy ribbon is oxidized by heating at a constant temperature of 400 °C in flowing pure oxygen gas until it is almost completely oxidized. The temperature is then raised to a maximum oxidation temperature less than the melting point of Ag metal (960 °C) and held there until the sample weight is approximately constant and the oxide is homogeneous with respect to composition. The temperature is then reduced to 490 °C and maintained at this temperature for approximately 18 h. The temperature is then reduced to room temperature.

During oxidation Ag is not oxidized, but rather precipitates out as a separate phase of substantially pure Ag. The metal phase, by being intimately mixed with the oxide phase, acts as a "skeleton" in the composite, resulting in improved ductility and strength.

### Example 2

The alloy ribbon prepared in Example 1 can be formed into a shape, e.g., a ring or coil, prior to oxidation and then oxidized to provide a superconducting oxide-metal composite in the desired shape.

### Example 3

A superconducting oxide-metal composite is prepared as in Example 1 but in the form of a wire by providing the alloy initially as a hot isostatically pressed compact of a rapidly solidified powder, ground-up rapidly solidified ribbon, or cast billet, and then forming it into a wire by wire drawing. The wire is then shaped by winding it around a metallic core and oxidized to prepare superconducting magnets. The wire can also be oxidized prior to shaping.

### Example 4

The alloy prepared in Example 1 is prepared as a rapidly solidified powder, rather than as a ribbon, and then hot isostatically pressed to form a useful shape, e.g., a ring. The shaped article is then oxidized to form a superconducting oxide-metal composite article.

### Example 5

A superconducting oxide-metal composite is prepared as in Example 1 except that the alloy is prepared by melting, then atomizing the liquid alloy using inert gas atomization to form a powder. The alloy powder is coextruded with a billet of a metal or metal alloy to yield a composite wire, rod, or tube. The coextruded product consists of a metal core coated with the alloy. The tube may be coated on the inside or outside surface, or both. The coating is then oxidized to form the superconducting oxide metal composite. In this case, the metal or metal alloy substrate can form a metallurgical bond with the noble metal phase of the composite, thereby promoting adhesion of the coating.

### Example 6

An alloy coating is prepared by running a metal or metal alloy wire through a bath of the molten alloy to form the coating. The hot dipping process is carried out in vacuo or under an inert atmosphere to avoid premature oxidation of the alloy. The coating is then oxidized to form the superconductive oxide-metal composite as in Example 1.

### Example 7

An alloy is prepared as in Example 1, but in the form of a coating on a substrate by spray deposition, sputtering, or plasma spraying. Oxidation produces a superconductive oxide-metal composite coating.

### Example 8

A thin film of the alloy described in Example 1 is deposited by, e.g., chemical vapour deposition, vacuum evaporation, sputtering, molecular beam epitaxy, ion beam mixing, or ion implantation, on a metallic, insulating, or semiconducting substrate. The thin film is then oxidized to form a thin film superconducting metal-oxide composite. This procedure is particularly useful in integrated circuit fabrication, and can be used to produce, e.g., Josephson junction devices.

## Claims

1. Superconducting oxide-metal composite comprising a substantially continuous oxide superconducting phase intimately mixed with a noble metal phase, the noble metal acting as a skeleton in the composite, thereby providing it with improved strength and ductility,
obtainable by
- combining the metallic elements of the oxide and a noble metal to form an alloy,
- forming the alloy into a desired shape,
- oxidizing the formed alloy in a first heating step at a first temperature in oxygen or in an oxygen-containing atmosphere,
and
- raising the temperature to a second temperature higher than the first temperature and lower than the melting temperature of the noble metal to form the superconducting oxide phase in a second heating step at that second temperature,
until the weight of the sample is constant.

2. Composite according to claim 1, **characterized in that** the oxide phase comprises an oxide of metallic elements selected from La, Ba, Cu, Y and Sr.

3. Composite according to claim 2, **characterized in that** the oxide phase comprises an oxide of La, Ba and Cu, of La, Sr and Cu, or of Y, Ba and Cu.

4. Composite according to claim 1, **characterized in that** the oxide phase comprises an oxide of Lu, Ba and Cu, or of Lu, Sr, and Cu, or of Eu, Ba and Cu.

5. Composite according to any of claims 1 to 4, **characterized in that** the noble metal phase comprises Ag, Pt, Au or Pd.

6. Composite according to any of claims 1 to 5, **characterized in that** the composite is in the form of a thin film, a coating, or a shaped article.

7. Composite according to any of claims 1 to 6, **characterized in that** the composite is in the form of a ribbon, a rod, or a ring, or of a wire, preferably wrapped around a metallic core to form a superconducting magnet.

8. Superconducting oxide-metal coil comprising an elongated tape of a superconducting oxide metal composite according to any of claims 1 to 7, the tape being configured in the shape of a coil.

9. Superconducting oxide magnet, comprising:
a metallic core, and
a composite wire wound around the metallic core, the composite wire comprising a superconducting oxide-metal composite according to any of claims 1 to 7.

10. Superconducting oxide wire, comprising:
a normal metal or metal alloy core, and
an oxide superconductor composite layer according to claim 1, a metallurgical bond being formed between the noble metal phase of the composite and the metal core.

11. The article of any of claims 8 to 10, wherein the noble metal comprises silver.

## Patentansprüche

1. Supraleitendes Oxid-Metall-Verbundmaterial, das eine im wesentlichen kontinuierliche supraleitende Oxidphase aufweist, die mit einer Edelmetallphase innig vermischt ist, wobei das Edelmetall in dem Verbundmaterial als Gerüst wirkt, wodurch es verbesserte Festigkeit und Duktilität erhält,
erhältlich durch
- Vereinigen der metallischen Elemente des Oxids und eines Edelmetalls unter Bildung einer Legierung,
- Formen der Legierung zu einer gewünschten Form,
- Oxidieren der geformten Legierung in einem ersten Erhitzungsschritt bei einer ersten Temperatur in Sauerstoff oder in einer Sauerstoff enthaltenden Atmosphäre
und
- Erhöhen der Temperatur auf eine gegenüber der ersten Temperatur höhere, zweite Temperatur, die niedriger ist als die Schmelztemperatur des Edelmetalls, unter Bildung der supraleitenden Oxidphase in einem zweiten Erhitzungsschritt bei dieser zweiten Temperatur bis zur Gewichtskonstanz der Probe.

2. Verbundmaterial nach Anspruch 1, **dadurch gekennzeichnet, daß** die Oxidphase ein Oxid von metallischen Elementen aufweist, die unter La, Ba, Cu, Y und Sr ausgewählt sind.

3. Verbundmaterial nach Anspruch 2, **dadurch gekennzeichnet, daß** die Oxidphase ein Oxid von La, Ba und Cu, von La, Sr und Cu oder von Y, Ba und Cu aufweist.

4. Verbundmaterial nach Anspruch 1, **dadurch gekennzeichnet, daß** die Oxidphase ein Oxid von Lu, Ba und Cu, von Lu, Sr und Cu oder von Eu, Ba und Cu aufweist.

5. Verbundmaterial nach einem der Ansprüche 1 bis 4, **dadurch gekennzeichnet, daß** die Edelmetallphase Ag, Pt, Au oder Pd aufweist.

6. Verbundmaterial nach einem der Ansprüche 1 bis 5, **dadurch gekennzeichnet, daß** es in Form eines dünnen Films, einer Beschichtung oder eines Formkörpers vorliegt.

7. Verbundmaterial nach einem der Ansprüche 1 bis 6, **dadurch gekennzeichnet, daß** das Verbundmaterial in Form eines Bandes, eines Stabes, eines Ringes oder eines Drahtes vorliegt, der vorzugsweise um einen metallischen Kern herumgewickelt ist, so daß ein supraleitender Magnet vorliegt.

8. Supraleitende Oxid-Metall-Spule, die ein längliches Band eines supraleitenden Oxid-Metall-Verbundmaterials nach einem der Ansprüche 1 bis 7 aufweist, wobei das Band in Form einer Spule ausgebildet ist.

9. Supraleitender Oxid-Magnet, der aufweist:
einen metallischen Kern und
einen Draht aus Verbundmaterial, der um den metallischen Kern herumgewickelt ist, wobei der Draht aus Verbundmaterial ein supraleitendes Oxid-Metall-Verbundmaterial nach einem der Ansprüche 1 bis 7 aufweist.

10. Supraleitender Oxid-Draht, der aufweist:
einen Kern aus einem normalen Metall oder einer Metall-Legierung und
eine Schicht aus einem supraleitenden Oxid-Verbundmaterial nach Anspruch 1, wobei zwischen der Edelmetallphase des Verbundmaterials und dem metallischen Kern eine metallurgische Bindung ausgebildet ist.

11. Gegenstand nach einem der Ansprüche 8 bis 10, wobei das Edelmetall Silber umfaßt.

## Revendications

1. Composite oxyde-métal supraconducteur comprenant une phase supraconductrice oxyde sensiblement continue mélangée intimement avec une phase de métal noble, le métal noble jouant le rôle de squelette dans le composite, pour lui conférer une résistance mécanique et une ductilité améliorées,
pouvant être obtenu en
- combinant les éléments métalliques de l'oxyde et un métal noble pour former un alliage,
- mettant l'alliage sous une forme voulue,
- oxydant l'alliage formé dans une première étape de chauffage à une première température dans l'oxygène ou dans une atmosphère contenant de l'oxygène, et
- augmentant la température jusqu'à une seconde température supérieure à la première température et inférieure à la température de fusion du métal noble pour former la phase oxyde supraconductrice dans une seconde étape de chauffage à cette seconde température,
jusqu'à ce que la masse de l'échantillon soit constante.

2. Composite selon la revendication 1, **caractérisé en ce que** la phase oxyde comprend un oxyde d'éléments métalliques choisis parmi La, Bu, Cu, Y et Sr.

3. Composite selon la revendication 2, **caractérisé en ce que** la phase oxyde comprend un oxyde de La, Ba et Cu, de La, Sr et Cu ou de Y, Ba et Cu.

4. Composite selon la revendication 1, **caractérisé en ce que** la phase oxyde comprend un oxyde de Lu, Ba et Cu, ou de Lu, Sr et Cu ou de Eu, Ba et Cu.

5. Composite selon l'une quelconque des revendications 1 à 4, **caractérisé en ce que** la phase de métal noble comprend Ag, Pt, Au ou Pd.

6. Composite selon l'une quelconque des revendications 1 à 5, **caractérisé en ce que** le composite est sous forme d'une couche mince, d'un revêtement ou d'un article mis en forme.

7. Composite selon l'une quelconque des revendications 1 à 6, **caractérisé en ce que** le composite est sous forme d'un ruban, d'une barre ou d'un anneau, ou d'un fil, de préférence enroulé autour d'un noyau métallique pour former un aimant supraconducteur.

8. Bobine oxyde-métal supraconductrice comprenant une bande allongée d'un composite oxyde-métal supraconducteur selon l'une quelconque des revendications 1 à 7, la bande étant configurée sous forme d'une bobine.

9. Aimant oxyde supraconducteur comprenant :
un noyau métallique, et
un fil composite enroulé autour du noyau métallique, le fil composite comprenant un composite oxyde-métal supraconducteur selon l'une quelconque des revendications 1 à 7.

10. Fil oxyde supraconducteur comprenant :
un noyau en métal ou alliage métallique normal, et
une couche de composite supraconducteur oxyde selon la revendication 1, une liaison métallurgique étant formée entre la phase métal noble du composite et le noyau métallique.

11. Article selon l'une quelconque des revendications 8 à 10 où le métal noble comprend de l'argent.
